# EUROPEAN PATENT SPECIFICATION

(11) **EP 2 894 954 B1**
(45) Date of publication and mention of the grant of the patent: **11.08.2021**
(21) Application number: 14811749.2
(22) Date of filing: 02.12.2014
(51) Int. Cl.: H05K 7/20, H01L 23/367, H01L 21/48

(54) **HEAT DISSIPATION HOUSING STRUCTURE CONNECTED TO HEAT DISSIPATION FIN**
WÄRMEABLEITENDES GEHÄUSE MIT INTEGRIERTEN KÜHLRIPPEN
STRUCTURE DE BOÎTIER À DISSIPATION DE CHALEUR CONNECTÉE À DES AILETTES DE DISSIPATION DE CHALEUR

(30) Priority: 06.12.2013 CN 201310649400; 06.12.2013 CN 201310649403; 06.12.2013 CN 201310649404; 06.12.2013 CN 201310649405; 11.03.2014 CN 201410087199
(43) Date of publication of application: 15.07.2015
(73) Proprietor: Marchesi Metal Technology (Suzhou) Co., Ltd, Suzhou Industrial Park Suzhou, Jiangsu 215000 (CN)
(72) Inventor: CHEN, Weiguo, Suzhou Jiangsu 215000 (CN); CAMPIDELLI, Veronica, Jiangsu 215000 (CN)
(74) Representative: Loyer & Abello
(86) International application number: PCT/CN2014/092766
(87) International publication number: WO 2015/081842

(56) References cited:
- EP-A1- 2 620 239
- EP-A2- 2 618 092
- CN-A- 1 407 671
- CN-A- 103 607 872
- CN-A- 103 607 873
- CN-A- 103 619 142
- CN-A- 103 619 143
- CN-A- 103 796 457
- CN-U- 203 633 005
- CN-U- 203 633 006
- CN-U- 203 633 007
- CN-U- 203 633 047
- CN-U- 203 748 135
- CN-Y- 2 527 069
- CN-Y- 201 383 751
- JP-A- H1 131 771
- TW-U- M 441 308
- US-A- 6 085 830
- US-A1- 2009 194 255
- US-A1- 2013 153 192
- US-A1- 2013 233 528
- US-A1- 2013 255 927

## Description

### TECHNICAL FIELD

The present invention relates to the field of heat-sinks, in particularly, to a heat dissipating enclosure with integrated cooling fins having high thermal dissipation efficiency.

### BACKGROUND OF THE INVENTION

With the development of the electronic techniques, heat generation of the electronic devices becomes larger and larger along with the increase of the power they use; this brings a higher standard of requirement for the related heat dissipation needs. Furthermore, the outdoor electronic devices are designed to resist water, wind and all other atmospheric events. The housings of outdoor electronic devices are mostly made of the nonferrous alloy casting, a large part of them are made by die casting. The internal space and features of the housing are designed to host and protect the PCB (Printed Circuit Board) or other functional components. Generally, a plurality of cooling fins is built on the outer surfaces of the housing to reduce the temperature that is otherwise increased by the internal heat generating electronic components and boards.

Commonly, there are two kind of hosting structures used in the cast heat dissipating enclosures, one is a heat dissipating enclosure with cooling fins, which is manufactured completely by die casting, another is a heat dissipating enclosure with cooling fins, whose cooling fins are bonded with a bonding agent on a die casting base. There are disadvantages existing in the above two solutions as follows: 1. the first structure is restricted by the die casting process, therefore, the height of its cooling fins is limited by moulding needs. Higher and bigger fins make the enclosure too heavy to be handled and therefore not economically deployable on the fields. Moreover, the cooling fins are die-cast with draft so that the total weight of the heat dissipating enclosure is further increased to allow ejection from mould. Besides, as the alloy material of the cooling fins is the same as that of the heat dissipating enclosure; therefore, the coefficients of heat dissipating of the cooling fins and the heat dissipating enclosure are the same, which restricts the overall heat dissipating effects. 2. the cooling fins of second structure is bonded to the heat dissipating enclosure with a bonding agent. Therefore, the efficiency of the cooling fins is negatively affected by the aging of the bonding agent along with the further risk of having cooling fins dropping/disconnecting from the heat dissipating enclosure or losing thermal dissipation efficiency with the passing of the time. Besides, the total heat dissipating properties of the heat dissipating enclosure is directly related to the coefficient of heat dissipating of bonding agent which has a large variability according to the data sheet of the commercial products available on market, therefore making the process unreliable on the effective result of the heat dissipation performance of the enclosure.

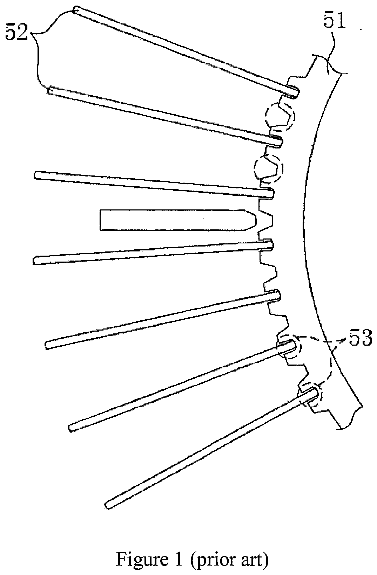

Refer to Figure 1, Patent 200920213960.0 discloses a heat dissipating structure including a Cricoid Lampholder 51, a plurality of Heat Dissipation Fins 52 and a plurality of Recesses 53 configured circlewise to the outer surfaces of the heating dissipating. Heat Dissipating Fins 52 could be inserted into Recesses 53 by bonding agent. The invention is aiming at dissipating the heat generated by the lamps through the heating dissipating fins. However, the heat dissipating fins is bonded to the Cricoid Lampholder 51 with the poorly heat dissipating bonding agent, which decreases the thermal dissipation efficiency.

Patent US2013/153192A1 discloses a heat dissipating device, which includes a base and a plurality of heat dissipating fins. The base includes a substrate and a box, wherein the substrate and the box are formed integrally and the box has an accommodating space therein. Each of the heat dissipating fins includes a heat dissipating portion, a fixing portion and an overflow-proof structure. The fixing portion is fixed in the base. The overflow-proof structure is connected between the heat dissipating portion and the fixing portion. A width of the overflow-proof structure is larger than a width of the heat dissipating portion and larger than a width of the fixing portion.

Patent EP2618092A2 discloses a heat dissipating device, which includes a base and a plurality of heat dissipating fins. The base includes a substrate and a box, wherein the box has an accommodating space therein. Each of the heat dissipating fins includes a heat dissipating portion, a fixing portion and an overflow-proof structure. The fixing portion is fixed in the base. The overflow-proof structure is connected between the heat dissipating portion and the fixing portion. A width of the overflow-proof structure is larger than a width of the heat dissipating portion and larger than a width of the fixing portion.

Patent US2013/233528A1 discloses a heat dissipating assembly, which includes a heat exchanger and a base. The heat exchanger defines at least one latching slot. A touching piece is surrounded the latching slot. The base includes at least one latching post. The touching piece is resiliently deformable to engage the at least one latching post in the at least one latching slot. The touching piece abuts the at least one latching post.

### SUMMARY OF THE INVENTION

The objection of the invention is to provide a heat dissipation housing structure connected to heat dissipation fins accommodating electronics components and board inside while allowing the lightest possible structural weight with high thermal dissipation efficiency without compromising the environmental and stress resistance performance compared to a conventional die casting process.

The "die casting" in the present invention refers to a casting process with molten or semi-liquid alloy material and with pressure, preferably, with high temperature and high pressure/density, the die casting process consists of casting metal alloy to attain dendritic solidification thereof under a pressure condition.

The mentioned alloy material is the no-ferrous alloys such as zinc alloy, aluminum alloy, and magnesium alloy and so on.

The cooling fins in the present invention are manufactured by extrusion forming or other cold forming methods. The cooling fins are also made by no-ferrous alloy such as aluminum alloy, magnesium alloy and so on.

To achieve the above goals of the present invention, technical solutions are applied as follows:
A heat dissipating enclosure with integrated cooling fins according to claim 1.

Due to the above technology, the beneficial effects of the invention are as follows:
(1) The long ridges are configured without changing the thickness of the heat dissipation housing compared to a traditional all-casting enclosure, so the cooling fins are fixed firmly, the material used is minimized while the heat dissipating effects and the strength are maintained, and the weight of the heat dissipation enclosure is decreased, cost is decreased.
(2) The bottom of the cooling fins is embedded and cast in the heat dissipation enclosure, so the problem that the bonding agent used at the heat dissipation enclosure is not consistent and low performing for heat dissipating is resolved, the thermal dissipation efficiency is increased. And manual bonding operations are not necessary anymore as the process is automatic and integrated in the casting stage, the production efficiency is raised. Meanwhile, the cooling fins are fastened tightly on the heat dissipation enclosure to prevent from drop over the time due to the aging of the bonding material, which ensures the heat dissipating capability. Further more the environmental protection aspects and the occupational disease prevention aspects are enhanced as the new technology does not require washing and preparing the hosting enclosure for the fins with chemical materials in order to have a good adhesion of the bonding agent; greatly reduce energy consumption as bonding agent curing oven manufacturing stage is not needed anymore. Last but not least the cycle time of the production and the lead time are greatly improved and stabilized.
(3) An overflow-preventing shape is configured above the bottom of the cooling fins, to prevent the overflow of metal fluid form the two sides of the cooling fin during casting, and that avoids the waste of the material. The cooling fins above the overflow-preventing shape are getting thicker gradually from top to bottom, to prevent the overflow of metal fluid to the two sides of the overflow-preventing shape. Meanwhile, the overflow-preventing shape extends all along two ends of the cooling fins, to further prevent the metal fluid from leaking outward from two sides of the cooling fins during casting, and that avoids the waste of the material.
(4) The long ridge is wrapped inside the skirted edge of the bottom of the cooling fins so that the casting internal stress is decreased efficiently, which prevents the long ridge from deformation.
(5) The cooling fins are featured by a hollow bottom surface open structure, to prevent metal fluid from leaking during casting, and avoid the waste of material.

The explanation described above is only overview of the present invention. To understand the technical methods of the invention clearly and implement the procedure in accordance with the specification, the following drawings and the preferred embodiments are listed. The description of the preferred embodiments is listed as below.

### BRIEF DESCRIPTIONS OF THE DRAWINGS

The drawings described here are used for better understanding of the invention, and it is part of the invention. The schematic embodiment of the invention is used for explanation, and it is not limiting the scope of the invention. In the drawings:
Figure 1 is a schematic view of cooling structure of Patent 200920213960.0;
Figure 2 is a partial view of the heat dissipating enclosure, not forming part of the invention;
Figure 3 is a section view of the heat dissipating enclosure, not forming part of the invention;
Figure 4a is a schematic view of the cooling fins whose cross section of the overflow-preventing shape is a rectangle, not forming part of the invention;
Figure 4b is a schematic view of the cooling fins whose cross section of the overflow-preventing shape is a triangle, not forming part of the invention;
Figure 4c is a schematic view of the cooling fins being thicker gradually in Figure 4a, not forming part of the invention;
Figure 4d is a schematic view of the cooling fins being thicker gradually in Figure 4b, not forming part of the invention;
Figure 5 is a schematic view of the cooling fins extending to the outside of the overflow-preventing shape, not forming part of the invention;
Figure 6 is a schematic view of the cooling fins with a plurality of bottom protrusions, not forming part of the invention;
Figure 7 is a left view of Figure 6;
Figure 8 is a section view of the heat dissipating enclosure, not forming part of the invention;
Figure 9a is a schematic view of the cooling fins whose bottom cross section is a triangle, not forming part of the invention;
Figure 9b is a schematic view of the cooling fins whose bottom cross section is an inverted T-shape, not forming part of the invention;
Figure 9c is a schematic view of the cooling fins whose bottom cross section is a circle, not forming part of the invention;
Figure 9d is a schematic view of the cooling fins whose bottom cross section is an accumbent H-shape, not forming part of the invention;
Figure 9e is a schematic view of another embodiment of the cooling fins whose bottom cross section is an accumbent H-shape, not forming part of the invention;
Figure 9f is a schematic view of another embodiment of the cooling fins which is provided with slots, not forming part of the invention;
Figure 10 is a section view of the heat dissipating enclosure;
Figure 11a is a schematic view of the cooling fins whose skirted edge is a rectangle;
Figure 11b is a schematic view of the cooling fins whose skirted edge is a circle;
Figure 11c is a schematic view of the cooling fins whose skirted edge is an inverted trapezoid;
Figure 11d is a schematic view of the cooling fins whose skirted edge is a zigzag.

The reference number of the drawings is listed as below: 1, Heat Dissipation Enclosure; 11, Long Ridge; 11', Round Bosses; 12, Side Wall; 13, Outer Wall; 2, Cooling Fins; 21, Bottom; 22, Overflow-preventing Shape; 23, Skirted edge; 24, Slots; 3, Bottom Protrusions; 51, Cricoid Lampholder; 52, Heat Dissipation Fins; 53, Recess.

### DESCRIPTIONS OF THE PREFERRED EMBODIMENT

The following drawings in combination with the embodiments are the further explanation of the present invention. However, they are not deemed as the limitation of the present invention.

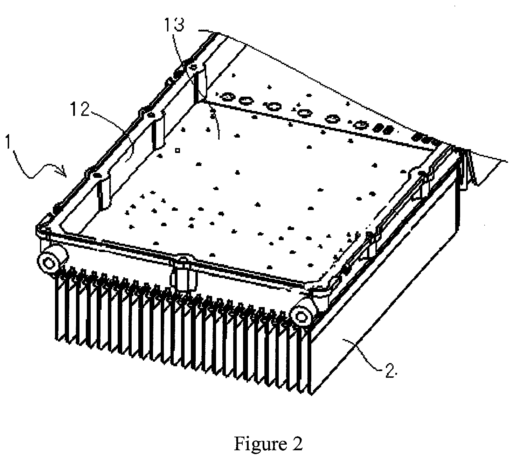

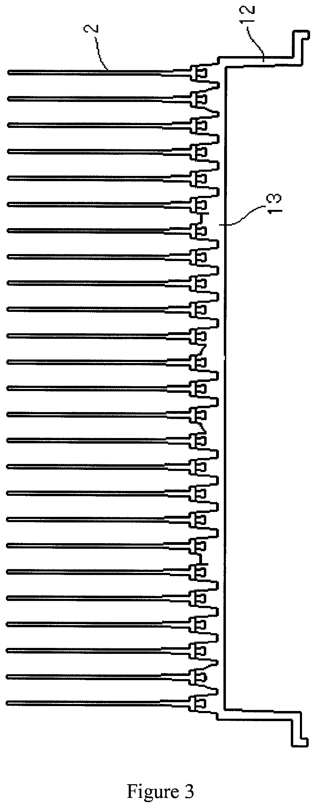

Refer to Figure 2 and Figure 3 (not forming part of the invention). A Heat Dissipating Enclosure 1 consists of an upper wall and a plurality of Side Walls 12. The upper wall and Side Walls forms an Outer Wall 13. A plurality of cooling fins 2 are cast into Outer Wall 13.

Further refer to Figure 3 (not forming part of the invention), Outer Wall 13 is provided with a plurality of cooling fins 2 which are configured with a same interval and in parallel to each other.

According to the above descriptions and figures, it is clear that the cooling fins are cast into the heat dissipating enclosure with out any bonding agent. Therefore, manual bonding process could be eliminated, which greatly increases the production efficiency and makes it possible for automatical production. Moreover, it also improves heat-conducting property and fastening reliability.

In an embodiment of the present invention, Bottom 21 of Cooling Fins 2 is cast in the Heat Dissipating Enclosure 1. As an embodiment of the present invention, Bottom 21 of Cooling Fins is provided with an Overflow-preventing Shape 22.

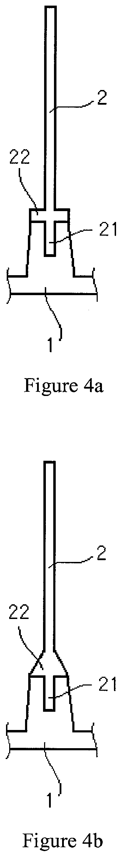

Refer to Figure 4a (not forming part of the invention), a shape of the section view of Overflow-preventing Shape 22 is a rectangle. The long side of the rectangle is contacted with the end face of Heat Dissipating Enclosure 1.

Refer to Figure 4b (not forming part of the invention), a shape of the section view of Overflow-preventing Shape 22 is a triangle. A right-angle side of the triangle is contacted with Heat Dissipating Enclosure 1.

Further refer to the actual use of the present invention, Bottom 21 of Cooling Fins is provided with an Overflow-preventing Shape 22 to prevent from the metal fluid from overflowing to Cooling Fins 2 during casing. Therefore, it saves the material.

To prevent the metal fluid overflows into Cooling Fins 2, Cooling Fins 2 which are located above Overflow-preventing Shape 22 are getting thicker from top to bottom.

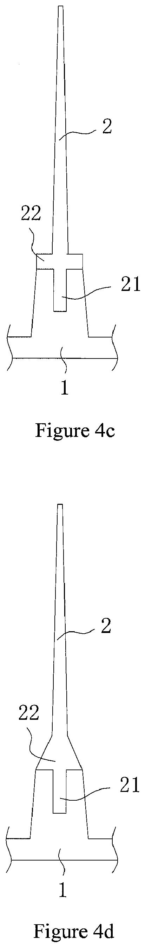

Refer to Figure 4c (not forming part of the invention), a shape of the section view of Overflow-preventing Shape 22 is a rectangle. The long side of the rectangle is contacted with the end face of Heat Dissipating Enclosure 1. Moreover, Cooling Fins 2 which are located above Overflow-preventing Shape 22 are getting thicker from top to bottom.

Refer to Figure 4d (not forming part of the invention), a shape of the section view of Overflow-preventing Shape 22 is a triangle. A right-angle side of the triangle is contacted with Heat Dissipating Enclosure 1. Moreover, Cooling Fins 2 which are located above Overflow-preventing Shape 22 are getting thicker from top to bottom.

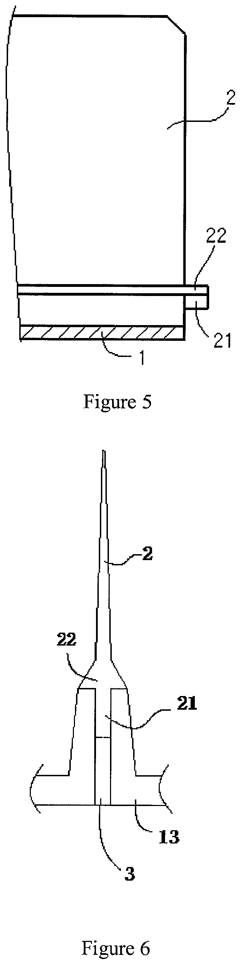

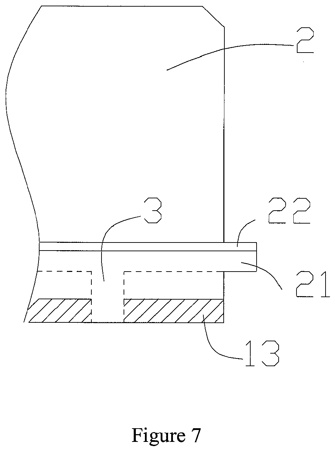

Refer to Figures 6 and 7 (not forming part of the invention), the bottom of Cooling Fins 2 is provided with a plurality of Bottom Protrusions 3. Bottom Protrusions 3 are used for limiting the position of Cooling Fins 2. After Cooling Fins 2 are connected to Heat Dissipating Enclosure 1, the lower surface of Bottom Protrusions 3 is at the same plane with Outer Wall 13.

As described above, Cooling Fins 2 are cast in Heat Dissipating Enclosure 1, which solved the problem that the bonding agent used for bonding Cooling Fins 2 in prior art is unbeneficial for heat conducting. Moreover, the heights of Cooling Fins 2 are not limited by casing process. The weight of Heat Dissipating Enclosure 1 is not increased as the Cooling Fins 2 is cast without any draft. The alloy material which forms Cooling Fins 2 could be different from the material forming Heat Dissipating Enclosure 1. Hence, the coefficient of heat release of Cooling Fins 2 could be different from that of Heat Dissipating Enclosure 1. The effect of heat dissipating is not restricted, which improves the efficiency of heat dissipating. Moreover, manual bonding process could be canceled, which greatly increases the production efficiency and makes it possible for automatical production. Moreover, Cooling Fins 2 could be fastened tightly at Heat Dissipating Enclosure 1, so that heat-conducting property and fastening reliability are improved.

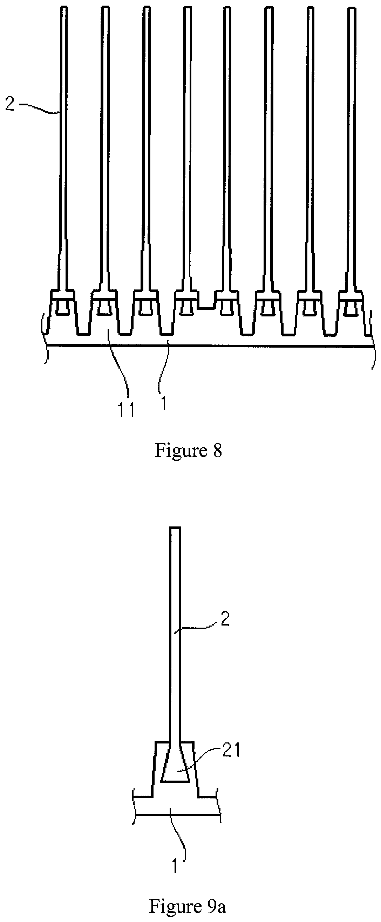

Refer to Figure 8 (not forming part of the invention), a Long Ridge 11 is configured at the place where Heat Dissipating Enclosure 1 is connected to Cooling Fins 2.

The height of Long Ridges 11 is bigger than the height of the Bottom 21 of Cooling Fins 2 to be embedded therein.

The shape of the section view of Long Ridge 11 is a rectangle. Long Ridge 11 extends along Heat Dissipating Enclosure 1. The long side of the rectangle is vertical to the Heat Dissipating Enclosure 1, and the short side of the rectangle is contacted to Cooling Fins 2.

As described above, due to the Long Ridge 11, Cooling Fins 2 could be fastened tightly at the Heat Dissipating Enclosure 1 without changing the thickness of the Heat Dissipating Enclosure 1. The use of the material could be decreased while the heat dissipating effect and strength are maintained.

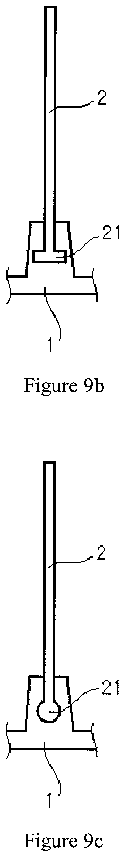

In Figure 9a (not forming part of the invention), the thickness of Bottom 21 of Cooling Fins 2 is larger than the thickness of the average thickness of Cooling Fins 2. Bottom 21 is cast into Heat Dissipating Enclosure 1.

Refer to Figure 9a (not forming part of the invention), a shape of the section view of Cooling Fins 2 is a rectangle. A side of the rectangle is in parallel with Heat Dissipating Enclosure 1. An angle formed by extending the other two sides of the rectangle is contacted with Bottom 21 of Cooling Fins 2.

Refer to Figure 9b (not forming part of the invention), a shape of the section view of Cooling Fins 2 is an inverted T-shape. The horizontal side of the T-shape is in parallel with Heat Dissipating Enclosure 1. The vertical side of the T-shape is in line and contacted with Cooling Fins 2.

Refer to Figure 9b (not forming part of the invention), a shape of the section view of Cooling Fins 2 is a circle.

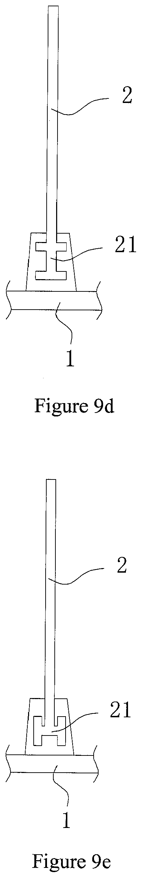

According to Figure 9d (not forming part of the invention), a shape of the section view of Cooling Fins 2 is an accumbent H-shape. The accumbent H-shape comprises two horizontal sides and a vertical side between the two horizontal sides. The horizontal side at the bottom of the accumbent H-shape is in parallel with Heat Dissipating Enclosure 1. The other side of the accumbent H-shape is vertical to Cooling Fins 2 directly. Refer to Figure 9e (not forming part of the invention), otherwise, the vertical side of the accumbent H-shape is vertical to Cooling Fins 2.

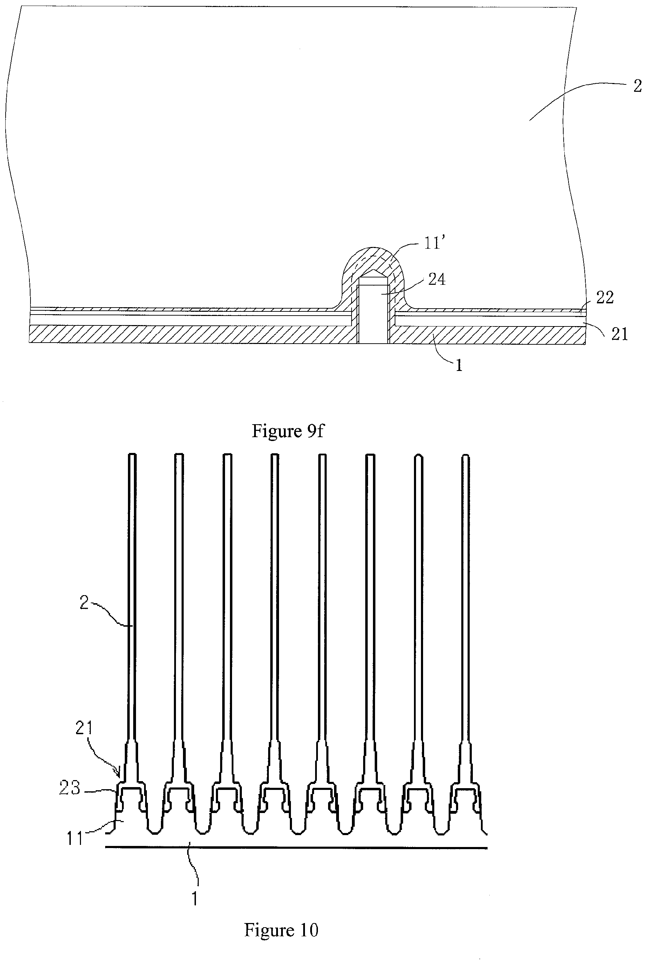

As shown in Figure 9f (not forming part of the invention), Cooling Fins 2 is provided with Slots 24 to avoid the threaded holes in Heat Dissipating Enclosure 1. Moreover, Round Bosses 11' are just configured at the corresponding places of Heat Dissipating Enclosure 1. Bottom 21 of Cooling Fins 2 is provided with a plurality of Slots 24 that mate with the casting bosses; wherein, the height of the casting Bosses 11' is larger than that of Slots 24

As described above with the figures, Bottom 21 of Cooling Fins 2 is configured in Heat Dissipating Enclosure 1 directly, which solves the problem that the bonding agent used for bonding Cooling Fins in prior art is unbeneficial for heat conducting. Hence, the thermal dissipation efficiency is increased. Bottom 21 of Cooling Fins 2 is cast in Heat Dissipating Enclosure 1, which makes it possible to cancel the manual bonding process. The production efficiency could be greatly improved and it is possible to achieve automatic production. Moreover, as Cooling Fins 2 are embedded in Heat Dissipating Enclosure 1, Cooling Fins 2 could be fastened tightly at Heat Dissipating Enclosure 1. Hence, Cooling Fins 2 are unlikely to drop and the normal heat sinking capability could be maintained.

In an embodiment of the present invention, refer to Figure 10, Heat Dissipating Enclosure 1 is provided with a plurality of Long Ridges 11. Bottom 21 of Cooling Fins 2 is cast in Long Ridges 11. Bottom 21 of Cooling Fins 2 is featured by hollow bottom surface open structure with two sides as Skirted edges 23. The bottom of Skirted edges 23 is folded inwards. Long Ridges 11 are cast into Skirted edges 23.

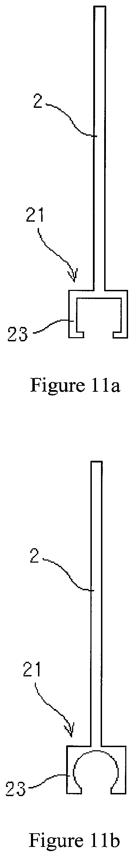

Refer to Figure 11a, a shape of the section view of the hollow bottom surface open structure is a rectangle. The long side of the rectangle is vertical to Cooling Fins 2, otherwise, the short of the rectangle is vertical to Cooling Fins 2.

Refer to Figure 11b, a shape of the section view of the hollow bottom surface open structure is a circle. The circle is a circle with major arc, otherwise, the circle is a circle with minor arc.

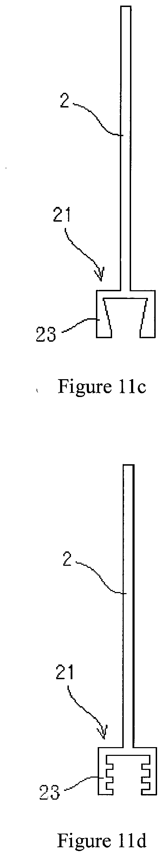

Refer to Figure 11c, a shape of the section view of the hollow bottom surface open structure is an inverted trapezoidal. The long side of the inverted trapezoidal faces to the upside where Cooling Fins 2 locates, and the short side of the inverted trapezoidal faces to the downside where Heat Dissipating Enclosure 1 locates.

Refer to Figure 11d, a shape of the section view of the hollow bottom surface open structure is a zigzag. The zigzag is formed by adding a plurality of protrusions onto the two inner sides of the hollow bottom surface open structure with the same intervals. The shape of the protrusions comprises rectangle, triangle and others. If the shape of the protrusions is rectangle, the short side of the rectangle of the protrusions is contacted to the inner sides of the hollow bottom surface open structure. If the shape of the protrusions is triangle, a side of the triangle of the protrusions is contacted to the inner sides of the hollow bottom surface open structure. An angle formed by extending the other two sides of the triangle is opposite to the center of the hollow bottom surface open structure.

According to an embodiment of the present invention, Long Ridge 11 of Heat Dissipating Enclosure 1 is provided with reserved structures mating the hollow bottom surface open structure of Skirted edges 23. The method for installing Cooling Fins 2 is as follows: let Skirted edges 23 of Cooling Fins 2 slide into Long Ridge 11 of Heat Dissipating Enclosure 1 from a side of Heat Dissipating Enclosure 1, and fixed by stamping Long Ridge 11 of Heat Dissipating Enclosure 1 or inserting it into the two ends of Skirted edges 23 of Cooling Fins 2.

The "die casting" in the present invention refers to a casting process with molten or semi-liquid alloy material and with pressure, preferably, with high temperature and high pressure/density, the die casting process consists of casting metal alloy to attain dendritic solidification thereof under a pressure condition . The mentioned alloy material is the no-ferrous alloys such as zinc alloy, aluminum alloy, magnesium alloy and so on.

The cooling fins in the present invention are manufactured by extrusion forming or other cold forming methods. The cooling fins are also made by no-ferrous alloy such as aluminum alloy, magnesium alloy and so on.

## Claims

1. A heat dissipating enclosure with integrated cooling fins, comprising
a heat dissipating enclosure (1) consisting of upper wall (13) and side walls (12);
the upper wall and side walls (12) forms an outer wall (13);
the cooling fins (2) are embedded and cast in the outer wall (13) of the heat dissipating enclosure (1);
a plurality of cooling fins (2) are connected to the outer wall (13);
a plurality of long ridges (11) are configured for the junctions between the heat dissipation enclosure (1) and the cooling fins (2);
which is **characterized in that** the height of the long ridges (11) is bigger than the height of the bottom (21) of the cooling fins (2) to be embedded therein;
a plurality of long ridges (11) are configured on the heat dissipating enclosure (1) evenly; the bottom (21) of each of the cooling fins (2) is embedded and cast in a corresponding one of the long ridges (11) of the heat dissipating enclosure (1);
the bottom (21) of each of the cooling fins (2) is featured by a hollow bottom surface open structure, two sides of the bottom (21) are fixed with skirted edges (23); bottoms of the skirted edges (23) are inward folded.

2. The heat dissipating enclosure with integrated cooling fins as disclosed in Claim 1, wherein a cross section of each of the long ridges (11) is rectangle or trapezoid in shape, or is a combination of rectangle and trapezoid in shape.

3. The heat dissipating enclosure with integrated cooling fins as disclosed in Claim 1, wherein a plurality of overflow-preventing shapes (22) are configured above the bottoms (21) of the cooling fins (2).

4. The heat dissipating enclosure with integrated cooling fins as disclosed in Claim 3, wherein a cross section of each of the overflow-preventing shape (22) is a rectangle or a triangle whose one leg is contacted with the heat dissipating enclosure (1).

5. The heat dissipating enclosure with integrated cooling fins as disclosed in Claim 3 or 4, wherein each of the cooling fins (2) above the overflow-preventing shapes (22) is getting thicker gradually from top to bottom.

6. The heat dissipating enclosure with integrated cooling fins as disclosed in Claim 3 or 4, wherein each of the overflow-preventing shapes (22) extends out all along the two sides of cooling fins (2).

7. The heat dissipating enclosure with integrated cooling fins as disclosed in Claim 1, wherein the hollow structure of the skirted edge (23) is one of or a combination of rectangle, circle, inverted trapezoid, or zigzag.

8. The heat dissipating enclosure with integrated cooling fins as disclosed in Claim 1, wherein the cooling fins (2) is provided with a plurality of bottom protrusions (3) to allow the fins reaching contact with the inner cavity of the casting enclosure (instead of being separated by a thin layer of casting alloy), flush with the casting base, so to better guide the fins vertical alignment during the casting process and to improve the heat transfer of the internal power generating components.

## Patentansprüche

1. Wärmeableitendes Gehäuse mit integrierten Kühlrippen, umfassend ein wärmeableitendes Gehäuse (1), das aus einer oberen Wand (13) und Seitenwänden (12) besteht;
wobei die obere Wand und die Seitenwände (12) eine Außenwand (13) bilden;
wobei die Kühlrippen (2) in der Außenwand (13) des wärmeableitenden Gehäuses (1) eingebettet und eingegossen sind;
wobei eine Vielzahl von Kühlrippen (2) mit der Außenwand (13) verbunden ist;
wobei eine Vielzahl von langen Stegen (11) für die Verbindung zwischen dem wärmeableitenden Gehäuse (1) und den Kühlrippen (2) konfiguriert ist;
**dadurch gekennzeichnet, dass** die Höhe der langen Stege (11) größer ist als die Höhe des Bodens (21) der darin einzubettenden Kühlrippen (2);
wobei eine Vielzahl von langen Stegen (11) gleichmäßig an dem wärmeableitenden Gehäuse (1) ausgebildet ist;
wobei der Boden (21) jeder der Kühlrippen (2) in einen entsprechenden der langen Stege (11) des wärmeableitenden Gehäuses (1) eingebettet und eingegossen ist;
wobei der Boden (21) jeder der Kühlrippen (2) als offene Struktur mit einer hohlen Bodenfläche ausgebildet ist, wobei zwei Seiten des Bodens (21) mit umlaufenden Kanten (23) festgelegt sind und die Unterseiten der umlaufenden Kanten (23) nach innen gefalzt sind.

2. Wärmeableitendes Gehäuse mit integrierten Kühlrippen nach Anspruch 1, wobei ein Querschnitt jedes der langen Stege (11) rechteckig oder trapezförmig oder eine Kombination aus einer Rechteckform und einer Trapezform ist.

3. Wärmeableitendes Gehäuse mit integrierten Kühlrippen nach Anspruch 1, wobei eine Vielzahl von ein Überlaufen verhindernden Formgebungen (22) über den Böden (21) der Kühlrippen ausgebildet ist.

4. Wärmeableitendes Gehäuse mit integrierten Kühlrippen nach Anspruch 3, wobei ein Querschnitt jeder der ein Überlaufen verhindernden Formgebungen (22) ein Rechteck oder ein Dreieck ist, dessen einer Schenkel sich mit dem wärmeableitenden Gehäuse (1) in Kontakt befindet.

5. Wärmeableitendes Gehäuse mit integrierten Kühlrippen nach Anspruch 3 oder 4, wobei jede der Kühlrippen (2) über den ein Überlaufen verhindernden Formgebungen (22) von oben nach unten allmählich dicker wird.

6. Wärmeableitendes Gehäuse mit integrierten Kühlrippen nach Anspruch 3 oder 4, wobei sich jede der ein Überlaufen verhindernden Formgebungen (22) entlang der beiden Seiten der Kühlrippen (2) erstreckt.

7. Wärmeableitendes Gehäuse mit integrierten Kühlrippen nach Anspruch 1, wobei die Hohlstruktur der umlaufenden Kante (23) rechteckig, kreisförmig, umgekehrt trapezförmig oder zickzackförmig oder eine Kombination dieser Formen ist.

8. Wärmeableitendes Gehäuse mit integrierten Kühlrippen nach Anspruch 1, wobei die Kühlrippen (2) mit einer Vielzahl von bodenseitigen Vorsprüngen (3) versehen ist, die ermöglichen, dass die Rippen (anstatt durch eine dünne Schicht einer Gusslegierung getrennt) mit dem inneren Hohlraum des gegossenen Gehäuses in Kontakt gelangen und bündig mit der Gussbasis abschließen, um so die vertikale Ausrichtung der Rippen während des Gießprozesses besser zu führen und die Wärmeübertragung der internen stromerzeugenden Komponenten zu verbessern.

## Revendications

1. Une enceinte de dissipation de chaleur avec des ailettes de refroidissement intégrées, comprenant
une enceinte de dissipation de chaleur (1) constituée d'une paroi supérieure (13) et de parois latérales (12) ;
la paroi supérieure et les parois latérales (12) forment une paroi extérieure (13);
les ailettes de refroidissement (2) sont encastrées et moulées dans la paroi extérieure (13) de l'enceinte de dissipation de chaleur (1) ;
une pluralité d'ailettes de refroidissement (2) sont reliées à la paroi extérieure (13) ;
une pluralité de longues nervures (11) sont configurées pour former les jonctions entre l'enceinte de dissipation de chaleur (1) et les ailettes de refroidissement (2) ;
**caractérisée en ce que** la hauteur des longues nervures (11) est plus grande que la hauteur du pied (21) des ailettes de refroidissement (2) à encastrer dans celles-ci ;
une pluralité de longues nervures (11) sont disposées sur l'enceinte de dissipation de chaleur (1) de manière régulière ; le pied (21) de chacune des ailettes de refroidissement (2) est encastré et moulé dans une nervure correspondante des longues nervures (11) de l'enceinte de dissipation de chaleur (1) ;
le pied (21) de chacune des ailettes de refroidissement (2) est **caractérisé par** une structure creuse ouverte de pied, deux côtés du pied (21) sont fixés avec des bords pliés (23) ; les fonds des bords pliés (23) sont pliés vers l'intérieur.

2. Enceinte de dissipation de chaleur avec des ailettes de refroidissement intégrées selon la revendication 1, dans laquelle une section transversale de chacune des longues nervures (11) est de forme rectangulaire ou trapézoïdale, ou est une combinaison des formes rectangulaire et trapézoïdale.

3. Enceinte de dissipation de chaleur avec des ailettes de refroidissement intégrées selon la revendication 1, dans laquelle une pluralité de formes anti-débordement (22) sont configurées au-dessus des pieds (21) des ailettes de refroidissement (2).

4. Enceinte de dissipation de chaleur avec des ailettes de refroidissement intégrées selon la revendication 3, dans laquelle une section transversale de chacune des formes anti-débordement (22) est un rectangle ou un triangle dont une jambe est en contact avec l'enceinte de dissipation de chaleur (1).

5. Enceinte de dissipation de chaleur avec des ailettes de refroidissement intégrées selon la revendication 3 ou 4, dans laquelle chacune des ailettes de refroidissement (2) au-dessus des formes anti-débordement (22) devient plus épaisse progressivement de haut en bas.

6. Enceinte de dissipation de chaleur avec des ailettes de refroidissement intégrées selon la revendication 3 ou 4, dans laquelle chacune des formes anti-débordement (22) s'étend tout le long des deux côtés des ailettes de refroidissement (2).

7. Enceinte de dissipation de chaleur avec des ailettes de refroidissement intégrées selon la revendication 1, dans laquelle la structure creuse des bords pliés (23) est l'un des motifs suivants ou une combinaison de ceux-ci : rectangle, cercle, trapèze inversé ou zigzag.

8. Enceinte de dissipation de chaleur avec des ailettes de refroidissement intégrées selon la revendication 1, dans laquelle les ailettes de refroidissement (2) sont pourvues d'une pluralité de saillies inférieures (3) pour permettre aux ailettes d'entrer en contact avec la cavité interne de l'enceinte de moulage (au lieu d'être séparées par une mince couche d'alliage de moulage), au niveau de la base de moulage, de manière à mieux guider l'alignement vertical des ailettes pendant le processus de moulage et à améliorer le transfert de chaleur des composants internes de production d'énergie.
